# EUROPEAN PATENT APPLICATION

(11) **EP 4 580 372 A1**
(43) Date of publication of application: **02.07.2025**
(21) Application number: 24202983.3
(22) Date of filing: 26.09.2024
(51) Int. Cl.: H10K 59/131, H10K 59/38, H10K 59/80, H10K 59/35, G09G 3/3233

(54) **TRANSPARENT DISPLAY APPARATUS**

(30) Priority: 29.12.2023 KR 20230197912
(71) Applicant: LG Display Co., Ltd., Seoul 07336 (KR)
(72) Inventor: LEE, Chanwoo, 10845 Paju-si (KR)
(74) Representative: Beal, James Michael

(57) **Abstract**

Disclosed is a transparent display apparatus that may include a substrate, a transmissive area, a non-transmissive area having a light-emitting area where a light-emitting element is disposed, at least one power line disposed in the non-transmissive area on the substrate and extending in a first direction, at least one trench line disposed in the transmissive area on the substrate and extending in the first direction, and an auxiliary power contact part disposed in the transmissive area on the substrate, electrically connected to an auxiliary power line extending from the at least one power line in a second direction intersecting the first direction, and overlapping at least a portion of the at least one trench line.

## Description

### CROSS-REFERENCE TO RELATED APPLICATION

This application claims priority to Korean Patent Application No. 10- 2023-0197912 filed in the Republic of Korea on December 29, 2023.

### BACKGROUND

### Technical Field

The present disclosure relates to a transparent display apparatus.

### Description of the Related Art

With the development of the information society, the demand for display apparatuses for displaying images is increasing in various forms. In recent years, display apparatuses such as Liquid Crystal Display (LCD), Organic Light Emitting Display (OLED), Micro Light Emitting Diode (Micro LED Display), Quantum Dot Display (QD), etc. have been utilized.

More recently, there has been active research into transparent displays that not only display an image to the user, but also allow light to pass through to view objects or images located behind the display. A transparent display apparatus includes a display area where an image is displayed and a non-display area, and the display area can include a transmissive area that can transmit external light and a non-transmissive area. The transparent display apparatus may have a high light transmittance in the display area through the transmissive area.

Such transparent display apparatuses have a wide range of potential applications in that the image and background can be viewed together, but due to the wide range of applications and uses, they may need to be manufactured in multiple varieties (or different sizes). However, when transparent display apparatuses are manufactured in multiple varieties (or different sizes), there is a problem of high manufacturing costs and increased energy consumption due to an increase in the number of processes.

### SUMMARY

An aspect of the present disclosure is directed to providing a transparent display apparatus which may provide a cathode contact part with a simplified structure to realize high light transmittance.

Another aspect of the present disclosure is directed to providing a transparent display apparatus that can reduce an occurrence of defects due to moisture penetration.

Another aspect of the present disclosure is directed to providing a transparent display apparatus that can be manufactured in multiple varieties (or different sizes).

The objects of the present disclosure are not limited to the aforesaid, but other objects not described herein will be clearly understood by those skilled in the art from descriptions below.

A transparent display apparatus according to an embodiment of the present disclosure may include a substrate, a transmissive area, a non-transmissive area having a light-emitting area where a light-emitting element is disposed, at least one power line disposed in the non-transmissive area on the substrate and extending in a first direction, at least one trench line disposed in the transmissive area on the substrate and extending in the first direction, and an auxiliary power contact part disposed in the transmissive area on the substrate, electrically connected to an auxiliary power line extending from the at least one power line in a second direction intersecting the first direction, and overlapping at least a portion of the at least one trench line.

According to one or more embodiments of the present disclosure, a transparent display apparatus may be provided where a cathode contact part with a simplified structure to realize high light transmittance.

According to one or more embodiments of the present disclosure, a transparent display apparatus may be provided where an occurrence of defects due to moisture penetration may be reduced.

According to one or more embodiments of the present disclosure, a transparent display apparatus may be manufactured and provided in multiple varieties (or different sizes).

The effects of the present disclosure are not limited to the aforesaid, but other effects not described herein will be clearly understood by those skilled in the art from descriptions below.

The details of the present disclosure described in technical problem, technical solution, and advantageous effects do not specify essential features of claims, and thus, the scope of claims is not limited by the details described in detailed description of the invention.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain principles of the disclosure.
FIG. 1 illustrates a transparent display apparatus according to an embodiment of the present disclosure.
FIG. 2 illustrates a circuit diagram of a sub-pixel of a transparent display apparatus according to an embodiment of the present disclosure.
FIG. 3 illustrates the area A shown in FIG. 1, according to an embodiment of the present disclosure.
FIG. 4 illustrates the area B illustrated in FIG. 3, according to an embodiment of the present disclosure.
FIG. 5 illustrates the area C illustrated in FIG. 4, according to an embodiment of the present disclosure.
FIG. 6 is a cross-sectional view of the line I - I ' shown in FIG. 5, according to an embodiment of the present disclosure.
FIG. 7 is a cross-sectional view of line II-II' shown in FIG. 5, according to an embodiment of the present disclosure.
FIG. 8 is a cross-sectional view of the line III-III' shown in FIG. 5, according to an embodiment of the present disclosure.
FIG. 9 illustrates the area C shown in FIG. 4, according to another embodiment of the present disclosure.
FIG. 10 is a cross-sectional view of line IV-IV' shown in FIG. 9, according to another embodiment of the present disclosure.
FIG. 11 is a cross-sectional view of line V-V' shown in FIG. 9, according to another embodiment of the present disclosure.
FIG. 12 is another cross-sectional view of the line V - V' shown in FIG. 9, according to another embodiment of the present disclosure.
FIG. 13 is a cross-sectional view of the line VI-VI' shown in FIG. 9, according to another embodiment of the present disclosure.
FIG. 14 illustrates a transparent display apparatus, according to another embodiment of the present disclosure.
FIG. 15 illustrates the area D shown in FIG. 14, according to another embodiment of the present disclosure.
FIG. 16 is a cross-sectional view of lines VII-VII' shown in FIG. 15, according to another embodiment of the present disclosure.
FIG. 17 is another cross-sectional view of lines VII-VII' shown in FIG. 15, according to another embodiment of the present disclosure.
FIG. 18 illustrates the area D shown in FIG. 14, according to another embodiment of the present disclosure.
FIG. 19 is another cross-sectional view of lines VIII-VIII' shown in FIG. 18, according to another embodiment of the present disclosure.
FIG. 20 illustrates the area D shown in FIG. 14, according to another embodiment of the present disclosure.
FIG. 21 is a schematic cross-sectional view of lines IX-IX' shown in FIG. 20, according to another embodiment of the present disclosure.
FIG. 22 illustrates the area D shown in FIG. 14, according to another embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and/or convenience.

### DETAILED DESCRIPTION

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete, to assist those skilled in the art to understand the inventive concepts without limiting the protected scope of the present disclosure.

Shapes (e.g., sizes, lengths, widths, heights, thicknesses, locations, radii, diameters, and areas), sizes, ratios, angles, numbers, and the like disclosed herein, including those illustrated in the drawings are merely examples, and thus, the present disclosure is not limited to the illustrated details. Any implementation described herein as an "example" is not necessarily to be construed as preferred or advantageous over other implementations. It is, however, noted that the relative dimensions of the components illustrated in the drawings are part of the present disclosure.

When the term "comprise," "have," "include," "contain," "constitute," "made of," "formed of," or the like is used with respect to one or more elements, one or more other elements may be added unless a term such as "only" or the like is used. The terms used in the present disclosure are merely used in order to describe example embodiments, and are not intended to limit the scope of the present disclosure. The terms of a singular form may include plural forms unless the context clearly indicates otherwise.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element is "connected," "coupled," "attached," "adhered," or the like to another element, the element may not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element is "contacts," "overlaps," or the like with another element, the element may not only directly contact, overlap, or the like with another element, but also indirectly contact, overlap, or the like with another element with one or more intervening elements disposed or interposed between the elements, unless otherwise specified.

The term "at least one" should be understood as including any and all combinations of one or more of the associated listed items. For example, "at least one among a first element, a second element and a third element" may include all combinations of two or more elements selected from the first, second and third elements as well as each element of the first, second and third elements.

Features of various embodiments of the present disclosure may be partially or entirety coupled to or combined with each other, may be technically associated with each other, and may be variously inter-operated, linked or driven together. The embodiments of the present disclosure may be implemented or carried out independently of each other, or may be implemented or carried out together in a co-dependent or related relationship. In one or more aspects, the components of each apparatus according to various embodiments of the present disclosure are operatively coupled and configured.

In the following description, various example embodiments of the present disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

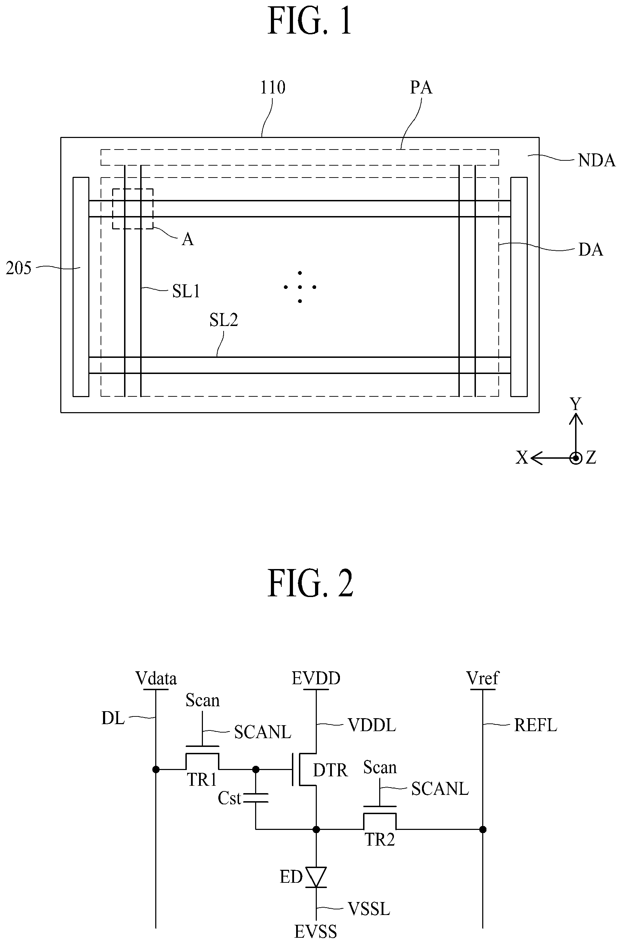

FIG. 1 illustrates a transparent display apparatus according to an embodiment of the present disclosure. FIG. 2 illustrates a circuit diagram of a sub-pixel of a transparent display apparatus according to an embodiment of the present disclosure.

Hereinafter, the X-axis refers to a direction in parallel with the scan line, the Y-axis refers to a direction in parallel with the data line, and the Z-axis refers to a height direction of the transparent display apparatus. As used herein, a transparent display apparatus may refer to a display apparatus at least part of which is transparent in the Z-axis direction, e.g. at least a transmissive area of the transparent display apparatus may be transparent in the Z-axis direction.

While the transparent display apparatus according to one embodiment of the present disclosure has been described with reference to an organic light emitting display (OLED), it can also be implemented as a liquid crystal display (LCD), a micro light emitting diode (Micro LED), a quantum dot (QD) display, and the like.

Referring to FIGS. 1 and 2, a transparent display apparatus according to one embodiment of the present disclosure may include a transparent display panel 110 comprising a display area DA with pixels to display an image and a non-display area NDA that does not display an image.

The display area DA of the transparent display panel 110 may include the first signal lines SL1, the second signal lines SL2, and pixels, and the non-display area NDA may include a pad area PA with pads disposed thereon and at least one gate driver 205.

The first signal lines SL1 may extend in the first direction (or Y-axis direction) and may intersect with the second signal lines SL2 in the display area DA. The second signal lines SL2 may extend in the second direction (or X-axis direction). Pixels may be disposed in the area where the first signal line SL1 and the second signal line SL2 intersect, and may emit a predetermined light to display an image.

A gate driver 205 may be connected to the scan line to supply a scan signal. The gate driver 205 may be implemented in a gate driver in panel (GIP) or tape automated bonding (TAB) on the non-display area NDA outside one or both sides of the display area DA of the transparent display panel 110.

The pad area PA of the transparent display panel 110 may be electrically connected to source driver integrated circuits, circuit boards, or timing controller, etc. that are connected via flexible circuit film.

Referring to FIG. 2, each of the pixels may include a plurality of sub-pixels constituting a unit pixel, and each of the plurality of sub-pixels may be equipped with a light emitting element ED and a circuit element having a 3T1C (3 transistor 1 capacitor) structure including a first switching transistor TR1, a second switching transistor TR2, a driving transistor DTR, and a capacitor Cst, but not necessarily limited to this. Each sub-pixel may further comprise a compensation circuit, and may have various circuit elements such as 4T2C, 5T2C, 6T1C, 6T2C, 7T1C, 7T2C, etc.

Each of the transistors (DTR, TR1, TR2) of each sub-pixel may include a gate electrode, a source electrode, and a drain electrode. The source electrode and the drain electrode are not fixed and may change depending on the direction of the voltage and current applied to the gate electrode. Thus, one of the source electrode and the drain electrode may be represented as the first electrode and the other as the second electrode. The transistors DTR, TR1, and TR2 of each sub-pixel may utilize at least one of a polysilicon semiconductor, an amorphous silicon semiconductor, and an oxide semiconductor. The transistors DTR, TR1, TR2 may be P-type or N-type, or a mixture of P-type and N-type.

The first switching transistor TR1 may serve to supply the data voltage Vdata supplied from the data line DL to the driving transistor DTR. For example, the first switching transistor TR1 may charge the capacitor Cst with the data voltage Vdata supplied from the data line DL. For this purpose, a gate electrode of the first switching transistor TR1 may be connected to the scan line SCANL (or gate line) and a first electrode of the first switching transistor TR1 may be connected to the data line DL. Further, a second electrode of the first switching transistor TR1 may be connected to one terminal of the capacitor Cst and a gate electrode of the driving transistor DTR.

The first switching transistor TR1 may be turned on in response to a scan signal Scan applied via the scan line SCANL (or gate line). When the first switching transistor TR1 is turned on, a data voltage Vdata applied via the data line DL may be transferred to the one terminal the capacitor Cst.

The second switching transistor TR2 may serve to supply a reference voltage Vref supplied from the reference line REFL to the driving transistor DTR. For example, a gate electrode of the second switching transistor TR may be connected to the scan line SCANL (or gate line) and a first electrode of the second switching transistor TR may be connected to the reference line REFL. Further, a second electrode of the second switching transistor TR2 may be connected to the first electrode of the driving transistor DTR and the other terminal of the capacitor Cst.

The second switching transistor TR2 may be turned on in response to a scan signal Scan applied via the scan line SCANL (or gate line). When the second switching transistor TR2 is turned on, a reference voltage Vref applied via the reference line REFL may be transferred to the other terminal of the capacitor Cst. In addition, the reference voltage Vref may also be applied to the source electrode of the driving transistor DTR.

The capacitor Cst may serve to maintain the data voltage Vdata supplied to the driving transistor DTR for one frame. For example, a first electrode of the capacitor Cst may be connected to the gate electrode of the driving transistor DTR and a second electrode of the capacitor Cst may be connected to the source electrode of the driving transistor DTR. The capacitor Cst may store a voltage corresponding to the data voltage Vdata transferred via the first switching transistor TR1, and may turn on the driving transistor DTR with the stored voltage.

The driving transistor DTR may serve to generate a data current from the first power supply EVDD supplied from the pixel power line VDDL (or the first power line) and supply it to the anode electrodes of the light emitting element ED. For example, a gate electrode of the driving transistor DTR may be connected to the one terminal of the capacitor Cst and a first electrode of the driving transistor DTR may be connected to the pixel power line VDDL. Further, a second electrode of the driving transistor DTR may be connected to an anode electrode of the light emitting element ED.

The light emitting element ED may comprise an anode connected to the driving transistor (DTR), a cathode supplied with a second power source EVSS from a common power line VSSL (or a second power line), and a light emitting layer between the anode and the cathode. The anode may be an independent electrode for each light emitting element, while the cathode may be a common electrode shared by all light emitting elements. When a driving current is supplied from a driving transistor DTR, electrons from the cathode are injected into the light emitting layer and holes from the anode are injected into the light emitting layer, and the recombination of electrons and holes in the light emitting layer causes the fluorescent or phosphorescent material to emit light with a brightness proportional to the current value of the driving current.

The light emitting element ED may have an anode connected to the second electrode of a driving transistor DTR and a cathode connected to a common power line VSSL. The light emitting element ED may emit light in response to a driving current generated by the driving transistor DTR.

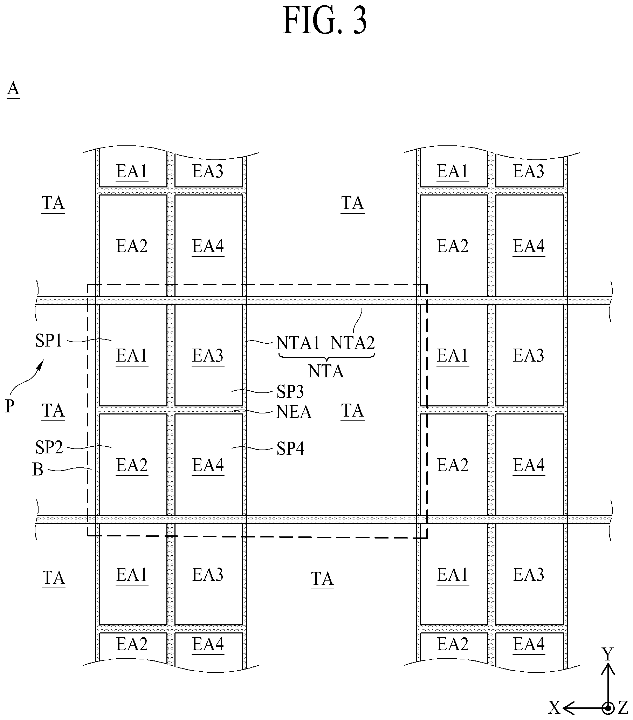

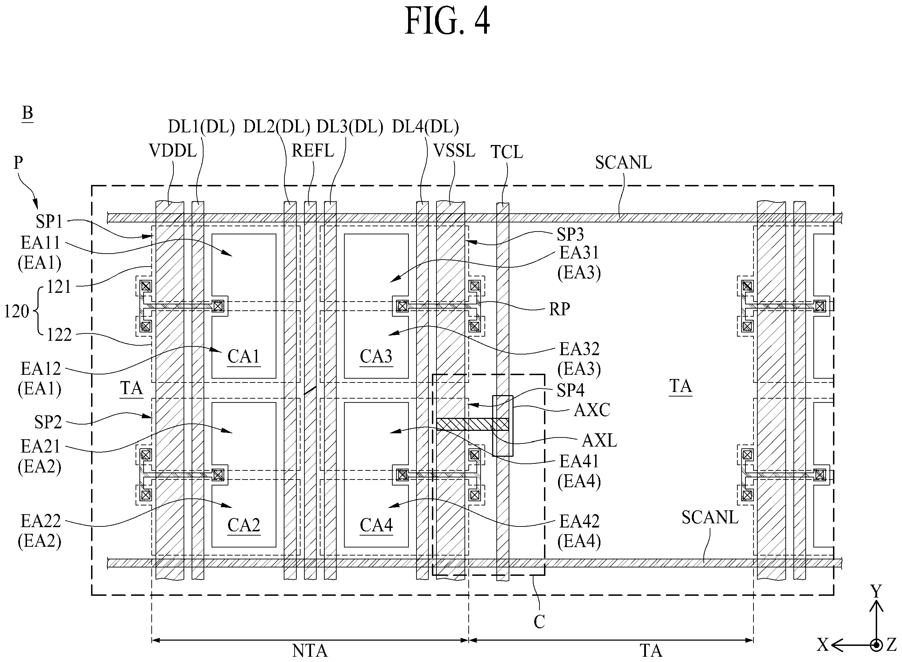

FIG. 3 illustrates the area A shown in FIG. 1 according to an embodiment of the present disclosure. FIG. 4 illustrates the area B illustrated in FIG. 3 according to an embodiment of the present disclosure.

Referring to FIG. 3 to FIG. 4 together with FIGS. 1 and 2, a transparent display panel 110 according to embodiments of the present disclosure may include a display area DA and a non-display area NDA. The display area DA may include a transmissive area TA and a non-transmissive area NTA. The transmissive area TA can be an area that allows most of the light incident from the outside to pass through, and the non-transmissive area NTA can be an area that does not allow most of the light incident from the outside to pass through. For example, a transmissive area TA may be an area with a light transmittance greater than α%, and a non-transmissive area NTA may be an area with a light transmittance less than β%. In this case, a may be a value greater than β. The transparent display panel 110 may allow users to see objects or backgrounds located behind the transparent display panel 110 due to the transmissive areas TA.

The non-transmissive areas NTAs may include a first non-transmissive area NTA1, a second non-transmissive area NTA2, and a pixel P.

The first non-transmissive area NTA1 extends in a first direction (or y-axis direction) from the display area DA and may be arranged to at least partially overlap with the light-emitting areas EA1, EA2, EA3, EA4. The first non-transmissive area NTA1 may comprise a plurality of first non-transmissive areas. The plurality of first non-transmissive areas NTA1 may extend in a first direction (or Y-axis direction) and may be spaced apart from each other in a second direction (or X-axis direction). Two neighboring first non-transmissive areas NTA1 may be spaced apart from each other with a transmissive area TA therebetween. For example, a transmissive area TA may be disposed between two neighboring first non-transmissive areas NTA1. The first non-transmissive area NTA1 may be disposed with a first signal lines SL1 extending in the first direction (or Y-axis direction). For example, the first signal lines SL1 may be overlapped with the first non-transmissive area NTA1.

The first signal lines SL1 may include at least one of a pixel power line VDDL (or first power line), a common power line VSSL (or second power line), a reference line REFL, and data lines DL1, DL2, DL3, DL4. For example, the first signal line SL1 may further include a touch sensor line, but embodiments of the present disclosure are not limited thereto.

The pixel power line VDDL (or first power line) may supply a first power supply EVDD to a driving transistor DTR of each of the sub-pixels SP1, SP2, SP3, SP4 provided in the display area DA.

The common power line VSSL (or the second power line) may supply a second power source EVSS to the cathode of the sub-pixels SP1, SP2, SP3, SP4 provided in the display area DA. In this case, the second power supply EVSS may be a common power supply common to the sub-pixels SP1, SP2, SP3, SP4.

The reference line REFL may supply an initialization voltage (or reference voltage) to the driving transistors DTR of each of the sub-pixels SP1, SP2, SP3, SP4 provided in the display area DA. For example, the reference line REFL may be disposed between the plurality of data lines DL1, DL2, DL3, DL4. For example, the reference line REFL may be disposed in the center between the plurality of data lines DL1, DL2, DL3, DL4.

Each of the data lines DL1, DL2, DL3, DL4 may supply a data voltage Vdata to the sub-pixels SP1, SP2, SP3, SP4. For example, the first data line DL1 may supply a first data voltage to a first driving transistor of the first sub-pixel SP1, and the second data line DL2 may supply a second data voltage to a second driving transistor of the second sub-pixel SP2, the third data line DL3 may supply a third data voltage to a third driving transistor of the third sub-pixel SP3, and the fourth data line DL4 may supply a fourth data voltage to a fourth driving transistor of the fourth sub-pixel SP4.

The second non-transmissive area NTA2 may extend in a second direction (or X-axis direction) from the display area DA and may be arranged to overlap at least partially with the light-emitting areas EA1, EA2, EA3, EA4. For example, the second non-transmissive area NTA2 may extend in the second direction (or X-axis direction) between two neighboring first non-transmissive areas NTA1. The second non-transmissive area NTA2 may comprise a plurality of second non-transmissive areas. The plurality of second non-transmissive areas NTA2 may extend in the second direction (or X-axis direction) and may be spaced apart from each other in the first direction (or Y-axis direction). The two neighboring second non-transmissive areas NTA2 may be spaced apart from each other with a transmissive area TA therebetween. For example, a transmissive area TA may be disposed between two neighboring second non-transmissive areas NTA2. The second non-transmissive area NTA2 may be disposed with a second signal lines SL2 extending in the second direction (or X-axis direction). For example, the second signal lines SL2 may be overlapped with the second non-transmissive area NTA2.

The second signal lines SL2 extend in the second direction (or X-axis direction) and may include scan lines SCANL (or gate lines). The scan line SCANL may supply scan signals to the sub-pixels SP1, SP2, SP3, SP4 of the pixel P.

The pixels P may be disposed at each intersection of the first non-transmissive area NTA1 and the second non-transmissive area NTA2, and may emit light to display an image. Each of the pixels P is disposed between neighboring transmissive areas TA, and the pixels P may include light-emitting areas EA1, EA2, EA3, EA4 in which light-emitting elements are disposed to emit light. The light-emitting areas EA1, EA2, EA3, EA4 may correspond to areas that emit light from the pixel P. Since the transparent display panel 110 has a small area of non-transmissive area NTA, circuit elements may be arranged to overlap the light-emitting areas EA1, EA2, EA3, EA4. For example, the light-emitting areas EA1, EA2, EA3, EA4 may overlap at least partially with the circuit areas CA1, CA2, CA3, CA4 in which the circuit elements are disposed. For example, the circuit areas CA1, CA2, CA3, CA4 may include a first circuit area CA1 in which circuit elements associated with a first subpixel SP1 are disposed, a second circuit area CA2 in which circuit elements associated with a second subpixel SP2 are disposed, a third circuit area CA3 in which circuit elements associated with a third subpixel SP3 are disposed, and a fourth circuit area CA4 in which circuit elements associated with a fourth subpixel SP4 are disposed.

Each of the pixels P is provided in a first non-transmissive area NTA1 and may emit light to display an image. Each of the pixels P may include a first sub-pixel SP1, a second sub-pixel SP2, a third sub-pixel SP3, and a fourth sub-pixel SP4. The first sub-pixel SP1 may include a first light-emitting area EA1 emitting a first color light, the second sub-pixel SP2 may include a second light-emitting area EA2 emitting a second color light, the third sub-pixel SP3 may include a third light-emitting area EA3 emitting a third color light, and the fourth sub-pixel SP4 may include a fourth light-emitting area EA4 emitting a fourth color light. The first to fourth sub-pixels SP1, SP2, SP3, SP4 may be arranged in a matrix in the form of a quad along the first direction (or Y-axis direction) and the second direction (or X-axis direction). For example, the first sub-pixel SP1 and the second sub-pixel SP2 may be disposed adjacent to the pixel power line VDDL (or the first power line), and the third sub-pixel SP3 and the fourth sub-pixel SP4 may be disposed adjacent to the common power line VSSL (or the second power line).

A scan line SCANL may be associated with each of the pixels P corresponding to a neighboring horizontal line. For example, a horizontal line may mean that a plurality of pixels P are disposed parallel with each other in a second direction (or X-axis direction). For example, a scan line SCANL may be connected to the pixels P corresponding to the upper horizontal line of two neighboring horizontal lines. For example, the upper horizontal line may be the horizontal line corresponding to the pixels P positioned upward relative to the pixels P shown in FIG. 4. For example, the scan line SCANL (or gate line) may be disposed adjacent to the first sub-pixel SP1 and the third sub-pixel SP3. Further, the scan line SCANL may be connected to the pixels P corresponding to the lower horizontal line of the two adjacent horizontal lines. For example, the lower horizontal line may be the horizontal line corresponding to the pixels P positioned lower relative to the pixels P shown in FIG. 4. For example, the scan lines SCANL (or gate lines) may be disposed adjacent to the second sub-pixel SP2 and the fourth sub-pixel SP4, but embodiments of the present disclosure are not limited thereto. For example, the scan lines SCANL may provide different scan signals to the pixels P corresponding to one horizontal line. For example, different scan signals may be provided to the pixels P corresponding to the horizontal lines corresponding to the pixels P shown in FIG. 4.

The first to fourth light-emitting areas EA1, EA2, EA3, EA4 may all emit different colors of light. For example, the first light-emitting area EA1 may emit green light, the second light-emitting area EA2 may emit blue light, the third light-emitting area EA3 may emit white light, and the fourth light-emitting area EA4 may emit red light, but embodiments of the present disclosure are not limited thereto. For example, the arrangement order or arrangement form of each sub-pixel SP1, SP2, SP3, SP4 may be varied.

The transparent display panel 110 according to embodiments of the present disclosure may include a plurality of light-emitting areas EA1, EA2, EA3, EA4, included in each of the plurality of sub-pixels SP1, SP2, SP3, SP4. For example, each of the plurality of sub-pixels SP1, SP2, SP3, SP4 may have a first electrode 120 (or anode electrode) of the light emitting element including a first split electrode 121 and a second split electrode 122 spaced apart from each other. Each of the first split electrode 121 and the second split electrode 122 may correspond to a divided light-emitting area. For example, the first light-emitting area EA1 provided in the first subpixel SP1 may include a first divided light-emitting area EA11 corresponding to the first split electrode 121 and a second divided light-emitting area EA12 corresponding to the second split electrode 122, respectively. The second light-emitting area EA2 provided in the second subpixel SP2 may include a first divided light-emitting area EA21 corresponding to the first split electrode 121 and a second divided light-emitting area EA22 corresponding to the second split electrode 122, respectively. The third light-emitting area EA3 provided in the third sub-pixel SP3 may include a first divided light-emitting area EA31 corresponding to the first split electrode 121 and a second divided light-emitting area EA32 corresponding to the second split electrode 122. The fourth light-emitting area EA4 provided in the fourth sub-pixel SP4 may include a first divided light-emitting area EA41 corresponding to the first split electrode 121 and a second divided light-emitting area EA42 corresponding to the second split electrode 122.

The first split electrode 121 and the second split electrode 122 may be electrically coupled to each other via a repair pattern RP. The repair pattern RP may serve to repair a dark ignition of either of the first split electrode 121 and the second split electrode 122. For example, the repair pattern RP may electrically connect the first split electrode 121 and the second split electrode 122 to circuit areas CA1, CA2, CA3, CA4 of each sub-pixel SP1, SP2, SP3, SP4. For example, the repair pattern RP may be organized in a "T" shape. One end of the repair pattern RP may be bifurcated and electrically connected to each of the first split electrode 121 and the second split electrode 122, and the other end of the repair pattern RP may be electrically connected to the circuit areas CA1, CA2, CA3, CA4 of each of the subpixels SP1, SP2, SP3, SP4. The repair pattern RP may act to disconnect electrical connections between the split electrode having a foreign material thereon and the circuit area when the foreign material is disposed on either of the first split electrode 121 and the second split electrode 122, thereby darkening only the split electrode having the foreign material thereon and repairing the remaining split electrodes to normal operation.

The pixel circuits CA1, CA2, CA3, CA4 of each of the plurality of sub-pixels SP1, SP2, SP3, SP4 may include a capacitor Cst, at least one thin film transistor DRT, TR1, TR2, and a light emitting element ED, as shown in FIG. 2. For example, the at least one thin film transistor DRT, TR1, TR2 may include a driving transistor DTR, a first switching transistor TR1, and a second switching transistor TR2. Further, the light emitting element ED may include a first electrode (or anode, pixel electrode), a light emitting layer (or organic light emitting layer), and a second electrode (or cathode, common electrode).

The transparent display panel 110 according to embodiments of the present disclosure may further include at least one trench line TCL extending in a first direction (or Y-axis direction) in the transmissive area TA.

The at least one trench line TCL may serve to cut off the light emitting layer (or organic light emitting layer) formed in the transmissive area TA. The at least one trench line TCL may comprise a portion of at least one protective layer (e.g., a planarization layer and a passivation layer). For example, the at least one trench line TCL may be formed by removing at least a portion of the at least one protective layer (e.g., the planarization layer and the passivation layer). Below the at least one trench line TCL, a scan line SCANL (or gate line) across the transmissive area TA may be disposed. The intersection of the at least one trench line TCL and the scan line SCANL may further comprise a block pattern BP. For example, the block pattern BP may prevent damage to the scan line SCANL intersecting the at least one trench line TCL below the at least one trench line TCL during the process of forming the at least one trench line TCL.

The at least one trench line TCL may be disposed adjacent to a common power line VSSL in the transmissive area TA. For example, the at least one trench line TCL may cutoff a light emitting layer (or organic light emitting layer) extending from the pixel P corresponding to the common power line VSSL. For example, the at least one trench line TCL may be formed by removing at least a portion of the at least one protective layer (e.g., a planarization layer and a passivation layer). For example, the at least one protective layer may comprise an organic insulating layer, and the at least one trench line TCL may be formed by removing at least a portion of the organic insulating layer, thereby cutting off or disconnecting the organic insulating layer. Thereby, moisture permeation from the outside of the at least one trench line TCL towards the pixel (P) may be prevented. Thus, a certain area including the transmissive area TA on the outside of the at least one trench line TCL may be cut by a cutting device such as a laser or a wheel, and moisture infiltration from the outside of the at least one trench line TCL may be prevented.

The transparent display panel 110 according to embodiments of the present disclosure may further comprise an auxiliary power contact part AXC disposed in the transmissive area TA and in contact with the second electrode (or cathode, common electrode) of the light emitting element ED.

The auxiliary power contact part AXC may be connected to a common power line VSSL to supply a second power source EVSS to the second electrode (or cathode) of the light emitting element ED. For example, the second power supply EVSS may be a common power supply common to the sub-pixels SP1, SP2, SP3, SP4.

The auxiliary power contact part AXC may be disposed in the transmissive area TA, electrically connected to an auxiliary power line AXL extending in a first direction (or X-axis direction) from the common power line VSSL, and may be disposed to overlap at least a portion of the at least one trench line TCL. For example, a portion of the auxiliary power contact part AXC may be exposed by the at least one trench line TCL. The exposed portion of the auxiliary power contact part AXC may be in direct contact with and electrically connected to the second electrode (or cathode) of the light emitting element ED.

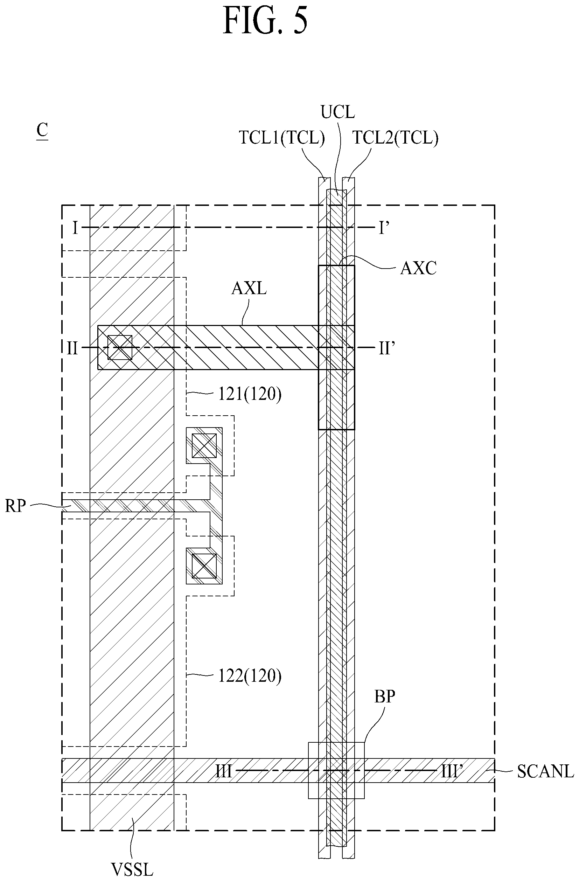

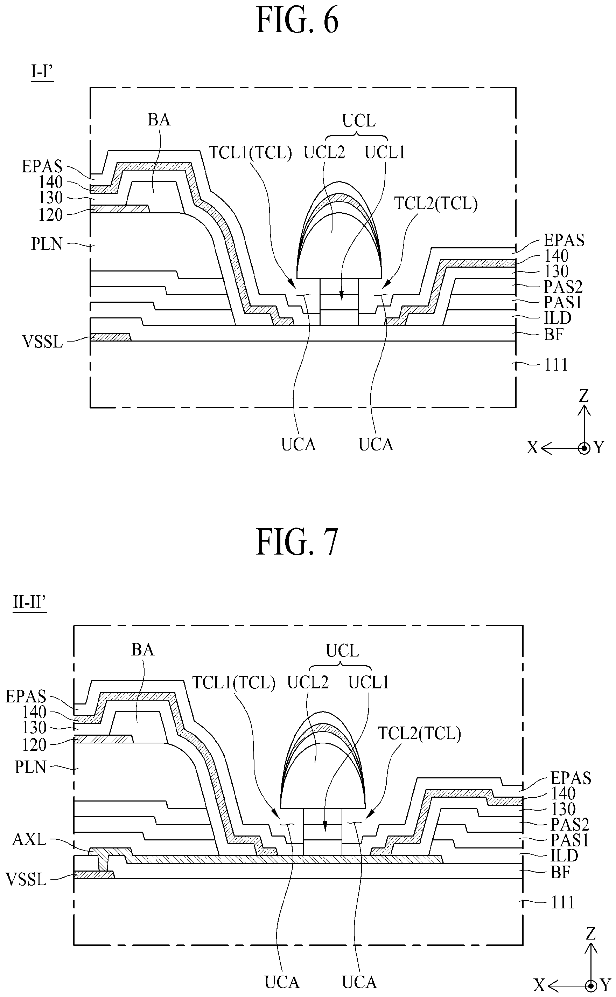

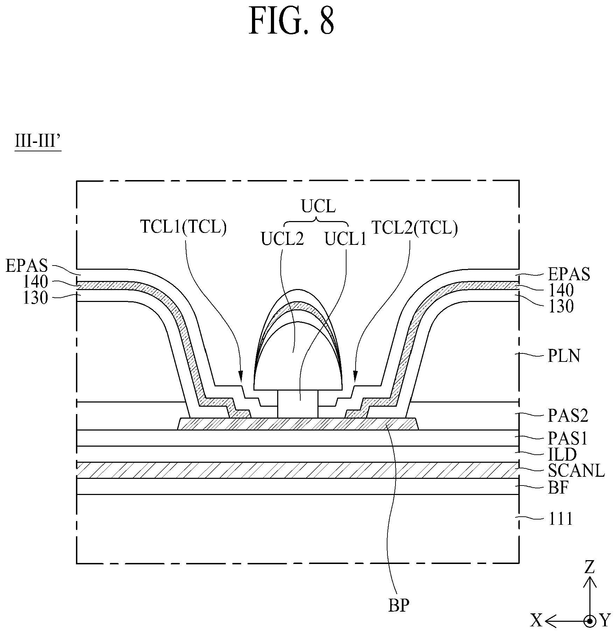

FIG. 5 illustrates the area C illustrated in FIG. 4, according to an embodiment of the present disclosure. FIG. 6 is a cross-sectional view of the line I - I ' shown in FIG. 5, according to an embodiment of the present disclosure. FIG. 7 is a cross-sectional view of line II-II' shown in FIG. 5, according to an embodiment of the present disclosure. FIG. 8 is a cross-sectional view of the line III-III' shown in FIG. 5, according to an embodiment of the present disclosure.

Referring to FIGS. 5 to 8 together with FIG. 4, a transparent display panel 110 according to one embodiment of the present disclosure may include a plurality of trench lines TCL1, TCL2 extending in a first direction (or Y-axis direction) in a transmissive area TA, an undercut line UCL extending in parallel with and between the plurality of trench lines TCL1, TCL2, and an auxiliary power contact part AXC overlapping at least a portion of the plurality of trench lines TCL1, TCL2.

Specifically, at least one of a data line DL, a pixel power line VDDL, a common power line VSSL, and a reference line REFL of the first signal lines may be disposed on the substrate 111. For example, as shown in FIGS. 6 and 7, a common power line VSSL may be disposed on the substrate 111. The common power line VSSL may extend in a first direction (or y-axis direction) from the non-transmissive area NTA on the substrate 111. Further, on the substrate 111, a pixel power line VDDL may be disposed opposite to the common power line VSSL, with the plurality of sub-pixels SP1, SP2, SP3, SP4 therebetween. Further, a plurality of data lines DL1, DL2, DL3, DL4 and a reference line REFL may be disposed on the substrate 111 between the common power line VSSL and the pixel power line VDDL. Further, a light shielding layer may be disposed on the substrate 111. For example, the shielding layer may serve to block external light from entering the active layer of the thin film transistor. The light shielding layer may comprise a single layer or multiple layers of any one of molybdenum (Mo), aluminum (Al), chromium (Cr), gold (Au), titanium (Ti), nickel (Ni), neodymium (Nd), and copper (Cu), or an alloy thereof. For example, a first signal line comprised of the same material in the same layer as the light shielding layer on the substrate 111 may be at least one of a data line DL, a pixel power line VDDL, a common power line VSSL, and a reference line REFL, but embodiments of the present disclosure are not limited thereto.

A buffer layer BF may be disposed on the substrate 111 where the common power line VSSL and the shielding layer are disposed. The buffer layer BF is intended to protect the thin film transistors from moisture penetrating through the substrate 111, which may be vulnerable to moisture permeation, and may comprise a single layer or multiple layers comprising an inorganic insulating material such as silicon oxide (SiOx), silicon nitride (SiNx), or aluminum oxide (Al₂O₃).

At least one insulating layer, a thin film transistor, and at least one signal line may be disposed on the buffer layer BF. For example, as shown in FIG. 7, an auxiliary power line AXL may be disposed on the buffer layer BF.

The auxiliary power line AXL may be electrically connected to the common power line VSSL through a contact hole penetrating the buffer layer BF. The auxiliary power line AXL may be connected to the common power line VSSL, extend in the second direction (or X-axis direction) to be disposed in the transmissive area TA. The auxiliary power line AXL may be electrically connected between the common power line VSSL and the auxiliary power contact part AXC. Further, at least one of the data line DL, the pixel power line VDDL, the common power line VSSL, and the reference line REFL of the first signal lines may be disposed on the buffer layer BF, but embodiments of the present disclosure are not limited thereto. Further, on the buffer layer BF, a scan line SCANL (or gate line) that is a second signal line may be disposed in the non-transmissive area NTA and the transmissive area TA. For example, at least a portion of the scan line SCANL may be disposed to extend in the second direction (or X-axis direction) to cross the transmissive area TA. Further, a thin film transistor may be disposed on the buffer layer BF. For example, the thin film transistor may include an active layer, a gate insulating layer, a gate electrode, and a source/drain electrode disposed on the buffer layer BF. The gate insulating layer may be disposed between the active layer and the gate electrode. For example, the gate insulating layer may be formed to overlap only the region where the gate electrode is disposed. An interlayer dielectric layer ILD may be disposed between the gate electrode and the source/drain electrode of the thin film transistor.

The auxiliary power contact part AXC may be formed of the same material in the same layer as the auxiliary power lines AXL. For example, the auxiliary power contact part AXC may be integrally formed with the auxiliary power line AXL. For example, the auxiliary power contact part AXC may be formed by an extension of the area of the auxiliary power line AXL where it overlaps the at least one trench line TCL. The auxiliary power contact part AXC may be formed of a different material in a different layer than the auxiliary power line AXL. For example, at least one insulating layer may be disposed between the auxiliary power contact part AXC and the auxiliary power line AXL, and the auxiliary power contact part AXC and the auxiliary power line AXL may be electrically connected to each other via contact holes through the at least one insulating layer, but embodiments of the present disclosure are not limited thereto.

An interlayer dielectric layer ILD may be disposed on the substrate 111 on which the auxiliary power line AXL and the auxiliary power contact part AXC are disposed. For example, the interlayer dielectric layer ILD may be disposed between the gate electrode and the source/drain electrode of a thin film transistor. The ILD may comprise a single layer or multiple layers comprising an inorganic insulating material such as silicon oxide (SiOx), silicon nitride (SiNx), or aluminum oxide (Al₂O₃). The source/drain electrodes of a thin film transistor can be disposed on the interlayer dielectric layer ILD. At least one of a data line DL, a pixel power line VDDL, a common power line VSSL, and a reference line REFL of the first signal lines may be disposed on the interlayer dielectric layer ILD, but embodiments of the present disclosure are not limited thereto.

A first passivation layer PAS1 may be disposed on the interlayer dielectric layer ILD. On top of the first passivation layer PAS1, a second passivation layer PAS2 may be disposed. The first passivation layer PAS1 and the second passivation layer PAS2 may be formed as a single layer or multiple layers comprising an inorganic insulating material such as silicon oxide (SiOx), silicon nitride (SiNx), aluminum oxide (Al₂O₃). On the first passivation layer PAS1, at least one of a data line DL, a pixel power line VDDL, a common power line VSSL, and a reference line REFL of the first signal lines may be disposed, but embodiments herein are not limited thereto.

On the second passivation layer PAS2, a planarization layer PLN may be disposed to planarize the steps caused by the thin film transistors and the plurality of signal lines. The planarization layer PLN may be formed of an organic material such as an acryl resin, an epoxy resin, a phenolic resin, a polyamide resin, a polyimide resin, or the like.

On the planarization layer PLN, light emitting elements EDs comprising a first electrode 120, an organic light emitting layer 130 and a second electrode 140, and a bank layer BA may be disposed.

The first electrode 120 is disposed per sub-pixel SP1, SP2, SP3, SP4 and may be disposed in a non-transmissive area NTA. The first electrode 120 may be formed of a highly reflective metallic material, such as a laminated structure of aluminum and titanium (Ti/AI/Ti), a laminated structure of aluminum and ITO (ITO/AI/ITO), an Ag alloy, a laminated structure of Ag alloy and ITO (ITO/Ag alloy/ITO), a MoTi alloy, and a laminated structure of MoTi alloy and ITO (ITO/MoTi alloy/ITO). Ag alloys can be alloys of silver (Ag), palladium (Pd), and copper (Cu). The MoTi alloy may be an alloy of molybdenum (Mo) and titanium (Ti). The first electrode 120 may be an anode of the light emitting element ED. An organic light emitting layer 130 and a second electrode 140 may be disposed on the first electrode 120. The first electrode 120, the organic light emitting layer 130, and the second electrode 140 may constitute the light emitting element ED.

The bank layer BA may be disposed on the planarization layer PLN. The bank layer BA may be disposed between the first electrodes 120. For example, the bank layer BA may be configured to cover an edge of each of the first electrodes 120 and leave a portion of each of the first electrodes 120 exposed. The bank layer BA may comprise an organic film, such as an acryl resin, epoxy resin, phenolic resin, polyamide resin, polyimide resin, or the like.

The organic light emitting layer 130 may be disposed on the first electrode 120. The organic light emitting layer 130 may include a hole transporting layer, an emission material layer, and an electron transporting layer. For example, when a voltage is applied to the first electrode 120 and the second electrode 140, holes and electrons migrate to the organic light emitting layer 130 through the hole transporting layer and the electron transporting layer, respectively, and can combine with each other in the emission material layer to emit light. The organic light emitting layer 130 may be separated or disconnected by a plurality of trench lines TCLs and undercut lines UCLs.

The second electrode 140 may be a common layer common to the sub-pixels SP1, SP2, SP3, SP4 that applies the same voltage. The second electrode 140 may be formed of a transparent conductive material (TCO), such as ITO or IZO, which can transmit light, or a semi-transmissive conductive material, such as magnesium (Mg), silver (Ag), or an alloy of magnesium (Mg) and silver (Ag). If the second electrode 140 is formed of a semi-transmissive conductive material, the light emission efficiency may be increased by the micro cavity. The second electrode 140 may be a cathode of the light emitting element ED.

An encapsulation layer EPAS may be disposed on the light emitting element ED. The encapsulation layer EPAS may be configured to cover the second electrode 140 over the second electrode 140. The encapsulation layer EPAS may serve to prevent oxygen or moisture from permeating the organic light emitting layer 130 and the second electrode 140. For example, the encapsulating layer EPAS may comprise at least one inorganic film and may further comprise at least one organic film, but embodiments herein are not limited thereto.

The transparent display apparatus 110 according to one embodiment of the present disclosure may comprise a plurality of trench lines TCL1, TCL2 and undercut lines UCL using a planarization layer PLN and at least one insulating layer (e.g., interlayer dielectric layer ILD, first passivation layer PAS1, second passivation layer PAS2). For example, the plurality of trench lines TCL1, TCL2 may be formed by removing at least a portion of the at least one insulating layer.

The plurality of trench lines TCL1, TCL2 may be disposed in parallel with each other in a first direction (or y-axis direction) and spaced apart from each other in a second direction (or x-axis direction). The plurality of trench lines TCL1, TCL2 may be formed by removing at least one insulating layer on the buffer layer BF. The plurality of trench lines TCL1, TCL2 may be formed by removing the interlayer dielectric layer ILD, the first passivation layer PAS1, and the second passivation layer PAS2.

An undercut line UCL may be disposed between the plurality of trench lines TCL1, TCL2. The undercut line UCL may be formed by removing at least a portion of the planarization layer PLN and at least one insulating layer. The undercut line UCL may comprise a support line UCL1 comprising the at least one insulating layer, and an eave line UCL2 located on the support line UCL1, protruding from the support line UCL1, and comprising the planarization layer PLN. The undercut line UCL may comprise an undercut area UCA with a plurality of trench lines TCL1, TCL2. For example, the undercut line UCL may have an undercut area UCA that includes a lower edge of the eave line UCL2 and a side of the support line UCL1. For example, the undercut area UCA may be included in a plurality of trench lines TCLs. The undercut line UCL and the plurality of trench lines TCLs may be disposed adjacent to a common power line VSSL. Further, the undercut line UCL and the plurality of trench lines TCL may be disposed not to overlap the repair pattern RP.

The undercut line UCL and the plurality of trench lines TCL may be disposed over a portion of the auxiliary power contact part AXC, as shown in FIG. 7. The undercut line UCL and the plurality of trench lines TCL may be configured to expose a portion of the auxiliary power contact part AXC. For example, a portion of the auxiliary power contact part AXC may be exposed by the at least one trench line TCL. The exposed portion of the auxiliary power contact part AXC may be in direct contact with and electrically connected to the second electrode (or cathode) of the light emitting element ED.

Below the undercut line UCL and the plurality of trench lines TCL, a scan line SCANL (or gate line) across the transmissive area TA may be arranged. At the intersection of the undercut line UCL/the plurality of trench lines TCL and the scan line SCANL, a block pattern BP may be disposed. For example, the block pattern BP may be formed at the intersection of the undercut line UCL/the plurality of trench lines TCL and scan lines SCANL.

The block pattern BP is intended to prevent damage to the scan line SCANL from the etchant used when the undercut line UCL and the plurality of trench lines TCL are formed. For example, a block pattern BP may be formed between the undercut line UCL and the scan line SCANL. The block pattern BP may be formed on the first passivation layer PAS1. For example, the block pattern BP may be formed of the same material as the other signal lines formed on the first passivation layer PAS1. For example, the block pattern BP may be formed of the same material in the same layer as at least one of the data line DL, the pixel power line VDDL, the common power line VSSL, and the reference line REFL of the first signal line. Alternatively, the block pattern BP may be formed of the same material in the same layer as at least one of the auxiliary power line AXL and the auxiliary power contact part AXC, but embodiments of the present disclosure are not limited thereto.

The undercut line UCL and the plurality of trench lines TCL may be disposed adjacent to the common power line VSSL and may cut off the light emitting layer (or organic light emitting layer) extending from the pixel (P) corresponding to the adjacent common power line VSSL. Further, the undercut line UCL may be formed by removing at least a portion of the planarization layer PLN, which is an organic material, thereby cutting off the organic insulating layer. Thereby, the undercut line UCL and the plurality of trench lines TCL can cut off the organic light-emitting layer and the organic insulating layer of the transparent display panel 11 in the first direction (or Y-axis direction), and prevent moisture from entering the transmissive area TA or the bezel. Thus, even if a certain area including the transmissive area TA outside the undercut line UCL and the plurality of trench lines TCL is cut by a cutting device such as a laser or a wheel, moisture permeation from the outside by the undercut line UCL and the plurality of trench lines TCL may be prevented.

By configuring the transparent display panel 110 according to one embodiment of the present disclosure with the undercut line UCL and the plurality of trench lines TCL extending in the first direction (or Y-axis direction) and overlapping the auxiliary power contact part AXC within the transmissive area TA, the space of the transmissive area TA can be shared with the auxiliary power contact structure, thereby further securing the margin of the transmissive area TA and improving the light transmittance of the transparent display panel 110. Furthermore, the transparent display panel 110 according to one embodiment of the present disclosure can prevent moisture penetration from the transmissive area TA or bezel by the undercut lines UCL and the plurality of trench lines TCL. Thereby, the outer side of the boundary line by the undercut line UCL and the plurality of trench lines TCL may become a cuttable area that can prevent moisture penetration toward the pixel (P) even if it is cut (or separated). Thus, by providing a cuttable area by the undercut line UCL and the plurality of trench lines TCL in the transmissive area TA, the transparent display panel 110 according to an embodiment of the present disclosure can implement or realize a cuttable transparent display panel that can be divided into various sizes according to the field and usage to which the transparent display panel 110 is applied.

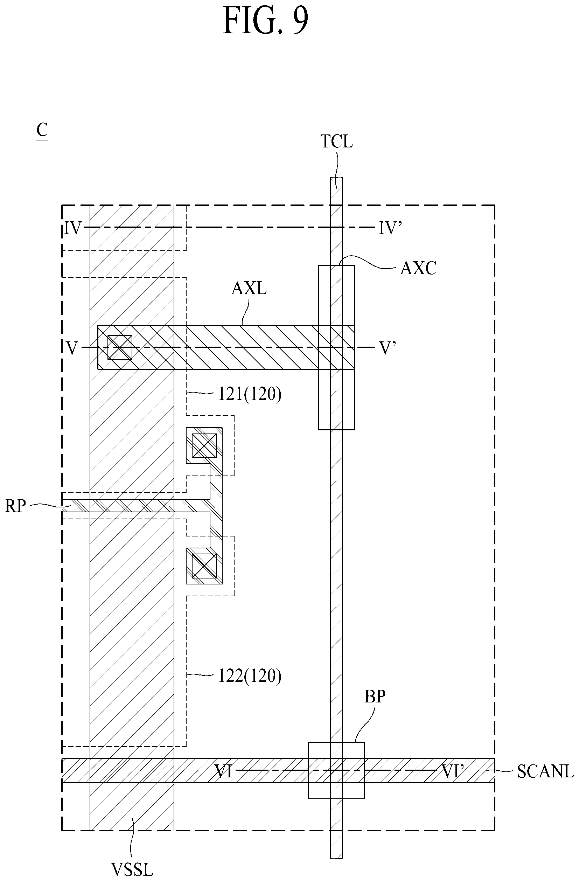

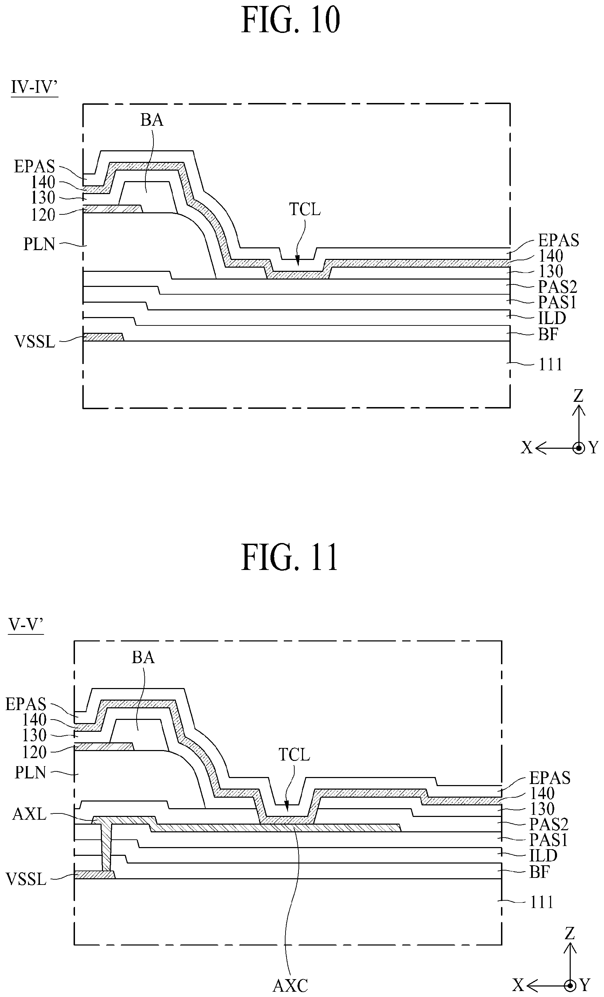

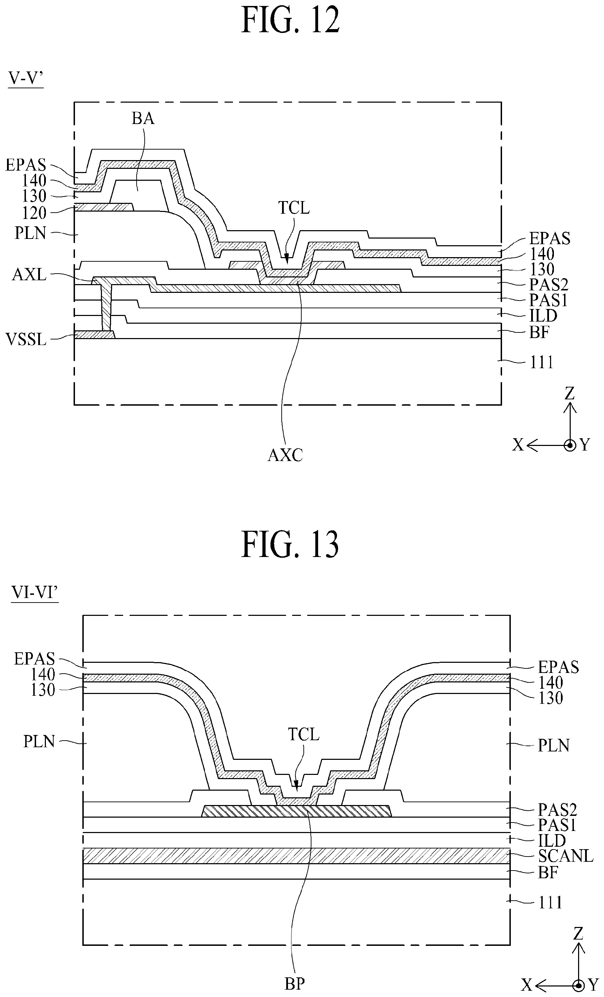

FIG. 9 illustrates the area C shown in FIG. 4, according to another embodiment of the present disclosure. FIG. 10 is a cross-sectional view of line IV-IV' shown in FIG. 9, according to another embodiment of the present disclosure. FIG. 11 is a cross-sectional view of line V - V' shown in FIG. 9, according to another embodiment of the present disclosure. FIG. 12 is another cross-sectional view of the line V-V' shown in FIG. 9, according to another embodiment of the present disclosure. FIG. 13 is a cross-sectional view of the line VI-VI' shown in FIG. 9, according to another embodiment of the present disclosure. FIGS 9 to 13 illustrate altered configurations of the trench line in the transparent display panel 110 described with reference to FIGS 1 to 8. In the following description, the same drawing reference are given to the same configuration except for the altered configuration, and redundant descriptions are omitted or shortened.

Referring to FIGS. 9 to 13, the transparent display panel 110 according to other embodiments of the present disclosure may include a trench line TCL extending in a first direction (or Y-axis direction) in the transmissive area TA, and an auxiliary power contact part AXC overlapping at least a portion of the trench line TCL.

On the substrate 111, a common power line VSSL among the first signal lines may be disposed. For example, at least one of a data line DL, a pixel power line VDDL, a common power line VSSL, and a reference line REFL formed of the same material in the same layer as the light shielding layer, may be disposed on the substrate 111, but embodiments of the present disclosure are not limited thereto.

At least one insulating layer may be disposed sequentially on the substrate 111. For example, the at least one insulating layer may include a buffer layer BF, an interlayer dielectric layer ILD, a first passivation layer PAS1, and a second passivation layer PAS2.

On the second passivation layer PAS2, a planarization layer PLN may be disposed to planarize the steps caused by the thin-film transistors and the plurality of signal lines. On the planarization layer PLN, light emitting elements (ED) comprising a first electrode 120, an organic light emitting layer 130, and a second electrode 140, and a bank layer BA may be disposed.

The transparent display panel 110 according to other embodiments of the present disclosure may be arranged with the organic light emitting layer 130 and the second electrode 140 of the light emitting elements (EDs) extending to the transmissive area TA. The organic light emitting layer 130 disposed in the transmissive area TA may be cut off or disconnected by at least one trench line TCL.

The at least one trench line TCL may be formed by removing at least a portion of the organic light emitting layer 130 disposed in the transmissive area TA. For example, the at least one trench line TCL may be configured by irradiating the transmissive area TA on the substrate 111 along the first direction (or Y-axis direction) with a laser after the formation of the organic light emitting layer 130 is completed in the manufacturing process of the transparent display panel 110, and cutting off or disconnecting the organic light emitting layer 130 in a line shape by the laser irradiation. For example, the organic light emitting layer 130 may not be present in the at least one trench line TCL. For example, the at least one trench line may be formed by a laser drilling process, but embodiments herein are not limited thereto.

The at least one trench line TCL may be configured to pass through the auxiliary power contact part AXC. For example, the auxiliary power contact part AXC may be disposed in a transmissive area TA. The auxiliary power contact part AXC may comprise a plurality of auxiliary power contact parts AXCs, and the plurality of auxiliary power contact parts AXCs may be disposed parallel with each other in the first direction (or Y-axis direction). The at least one trench line TCL may be configured by removing the organic light emitting layer 130 along the first direction (or Y-axis direction) to overlap the plurality of auxiliary power contact parts AXCs disposed parallel with each other. The at least one trench line TCL may expose a portion of the auxiliary power contact part AXC to the outside by removing the organic light emitting layer 130 on the auxiliary power contact part AXC.

In the manufacturing process of the transparent display panel 110, after the formation of the at least one trench line TCL is complete, a second electrode 140 may be formed, and the second electrode 140 may be in direct contact with the auxiliary power contact part AXC exposed by the at least one trench line TCL.

The auxiliary power contact part AXC may be disposed on the first passivation layer PAS1, as shown in FIG. 11. The auxiliary power contact part AXC may be connected to a common power line VSSL, connected to an auxiliary power line AXL extending in the second direction (or X-axis direction), or may be composed of the same material in the same layer of the auxiliary power line AXL. For example, the auxiliary power contact part AXC may be integrally formed with the auxiliary power line AXL. The auxiliary power contact part AXC may be integral with or connected to the auxiliary power line AXL to serve to apply a second power source (or a common voltage or low potential voltage) supplied from the common power line EVSS to the second electrode 140. The auxiliary power contact part AXC may have a portion exposed to the at least one trench line TCL in direct contact with the second electrode 140 to serve to lower the resistance of the second electrode 140.

The auxiliary power contact part AXC may be disposed in the second passivation layer PAS2, as shown in FIG. 12. The auxiliary power contact part AXC may be formed of a different material in a different layer than the auxiliary power line AXL. For example, the auxiliary power contact part AXC may be formed of the same material as the first electrode 120. The auxiliary power contact part AXC may be electrically connected to the auxiliary power line AXL via a contact hole through the second passivation layer PAS2 interposed between the auxiliary power line AXL and the auxiliary power contact part AXC. The auxiliary power contact part AXC may be integral with or connected to the auxiliary power line AXL and may serve to apply a second power source (or common voltage or low potential voltage) supplied from the common power line EVSS to the second electrode 140. The auxiliary power contact part AXC may have a portion exposed to the at least one trench line TCL in direct contact with the second electrode 140 to serve to lower the resistance of the second electrode 140.

A block pattern BP may be disposed at the intersection of the at least one trench line TCL and the scan line SCANL. For example, as shown in FIG. 13, the block pattern BP may be disposed on the first passivation layer PAS1. The block pattern BP is intended to prevent the scan line SCANL from being damaged by the laser when the at least one trench line TCL is formed. For example, the block pattern BP may be disposed between the trench line TCL and the scan line SCANL. For example, the block pattern BP may be constructed of the same material in the same layer as at least one of the auxiliary power line AXL and the auxiliary power contact part AXC formed on the first passivation layer PAS1. For example, the block pattern BP may be formed of the same material in the same layer as at least one of the data line DL, the pixel power line VDDL, the common power line VSSL, and the reference line REFL of the first signal line, but embodiments of the present disclosure are not limited thereto.

According to other embodiments of the present disclosure, the block pattern BP may be omitted. A plurality of insulating layers may be disposed between the at least one trench line TCL and the scan line SCANL. For example, an interlayer dielectric layer ILD, a first passivation layer PAS1, and a second passivation layer PAS2 may be disposed between the at least one trench line TCL and the scan line SCANL. Thereby, the scan line SCANL may not be damaged during the formation process of the at least one trench line TCL by laser irradiation, and thus the block pattern BP may be omitted.

According to other embodiments of the present disclosure, the at least one trench line TCL may be formed by removing at least a portion of the organic light emitting layer 130 and the second electrode 140 disposed in the transmissive area TA. For example, the at least one trench line TCL may be configured by, in the manufacturing process of the transparent display panel 110, after the formation of the organic light emitting layer 130 and the second electrode 140 is completed, using a laser to laser irradiate the transmissive area TA on the substrate 111 along the first direction (or Y-axis direction), and cutting off or disconnecting the organic light emitting layer 130 and the second electrode 140 in a line shape by the laser irradiation. For example, the organic light emitting layer 130 and the second electrode 140 may not be present in the at least one trench line TCL. For example, the at least one trench line (TCL) may be formed by a laser drilling process, but embodiments of the present disclosure are not limited thereto.

According to other embodiments of the present disclosure, the at least one trench line TCL may comprise a plurality of trench lines TCLs disposed parallel with each other in a first direction (or Y-axis direction) in the transmissive area TA and spaced apart from each other in a second direction (or X-axis direction). The plurality of trench lines TCLs may be disposed in multiples in the transmissive area TA to further prevent external moisture permeation.

By configuring the transparent display panel 110 according to other embodiment of the present disclosure with the trench line TCL extending in the first direction (or Y-axis direction) and overlapping the auxiliary power contact part AXC within the transmissive area TA, the space of the transmissive area TA can be shared with the auxiliary power contact structure with minimizing the removal area of the organic light emitting layer 130, thereby further securing the margin of the transmissive area TA and improving the light transmittance of the transparent display panel 110. Furthermore, the transparent display panel 110 according to other embodiment of the present disclosure can prevent moisture penetration from the transmissive area TA or bezel by the at least one trench line TCL. Thereby, the outer side of the boundary line by the at least one trench line TCL may become a cuttable area that can prevent moisture penetration toward the pixel (P) even if it is cut (or separated). Thus, by providing a cuttable area by the at least one trench line TCL in the transmissive area TA, the transparent display panel 110 according to other embodiment of the present disclosure can implement or realize a cuttable transparent display panel that can be divided into various sizes according to the field and usage to which the transparent display panel 110 is applied.

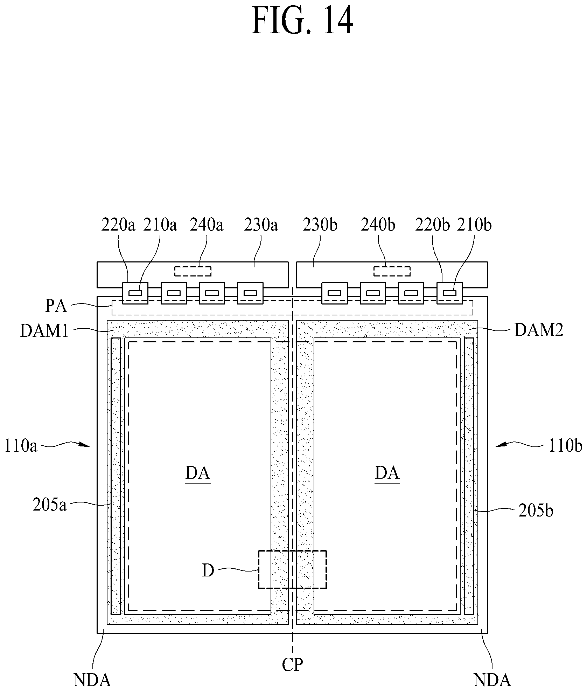

FIG. 14 illustrates a transparent display apparatus, according to another embodiment of the present disclosure.

Referring to FIG. 14, the transparent display panel 110 according to another embodiment of the present disclosure may include a display area DA configured with pixels to display an image and a non-display area NDA that does not display an image.

The transparent display panel 110 according to other embodiments of the present disclosure may include at least one trench line TCL extending from the non-display area NDA to the display area DA in a first direction (or Y-axis direction). The at least one trench line TCL may intersect and overlap with a pixel power or common power shorting bar disposed in the non-display area NDA, and may also be disposed in the display area DA to overlap with an auxiliary power contact part AXC disposed in the transmissive area TA.

The transparent display panel 110 may include dam patterns DAM1, DAM2 that divide display area DA into at least two areas. The dam patterns DAM1, DAM2 may be configured in the form of a closed loop that encloses at least a portion of a non-display area NDA (or bezel area) and the display area DA such that the display area DA is divided into at least two distinct areas. For example, the dam patterns DAM1, DAM2 may include a first dam pattern DAM1 and a second dam pattern DAM2.

The first dam pattern DAM1 may be configured to enclose a display area DA positioned to the left in the second direction (or X-axis direction). The second dam pattern DAM2 may be configured to enclose the display area DA positioned to the right in the second direction (or X-axis direction).

The first dam pattern DAM1 and the second dam pattern DAM2 may be spaced apart from each other in the second direction (or X-axis direction). Alternatively, the first dam pattern DAM1 and the second dam pattern DAM2 may be disposed such that at least a portion of the portions adjacent to each other overlap each other.

The transparent display panel 110 may include a plurality of gate drivers 205a, 205b. For example, the plurality of gate drivers 205a, 205b may include a first gate driver 205a and a second gate driver 205b. The first gate driver 205a may be disposed in a non-display area NDA positioned to the left in the second direction (or X-axis direction), and the second gate driver 205b may be disposed in a non-display area NDA positioned to the right in the second direction (or X-axis direction). For example, the first dam pattern DAM1 may be disposed to enclose the first gate driver 205a and a left portion of the display area DA, and the second dam pattern DAM2 may be disposed to enclose the second gate driver 205b and a right portion of the display area DA.

The transparent display panel 110 may include first and second source drive integrated circuits ("ICs") 210a, 210b, first and second flexible films 220a, 220b, first and second circuit boards 230a, 230b, and first and second timing controllers 240a, 240b.

The first source drive IC 210a, the first flexible film 220a, the first circuit board 230a, and the first timing controller 240a may be coupled to a left display area DA defined by a first dam pattern DAM1, and the second source drive IC 210b, the second flexible film 220b, the second circuit board 230b, and the second timing controller 240b may be coupled to a right display area DA defined by a second dam pattern DAM2.

A cutting part CP may be provided between the first dam pattern DAM1 and the second dam pattern DAM2. The cutting part CP is a portion where the transparent display panel 110 may be separated or cut by a cutting device, such as a laser or a wheel. For example, the display areas DA surrounded by the first and second dam patterns DAM1, DAM2 may be display areas DA of the transparent display panels 110a, 110b that are independent of each other by being separated or cut by the cutting part CP.

The first and second dam patterns DAM1, DAM2 may be non-display areas NDAs (or bezel areas) of each of the separated transparent display panels 110a, 110b. For example, the center portion of the display area DA that the first and second dam patterns DAM1, DAM2 traverse in the first direction (or Y-axis direction) may be a display area DA before the cut, but may be a non-display area NDA (or bezel area) after the cut.

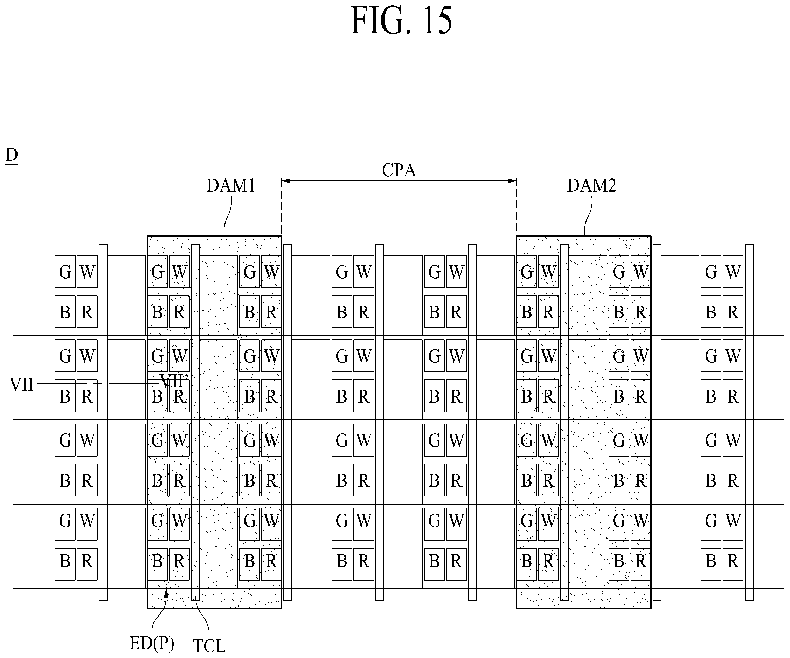

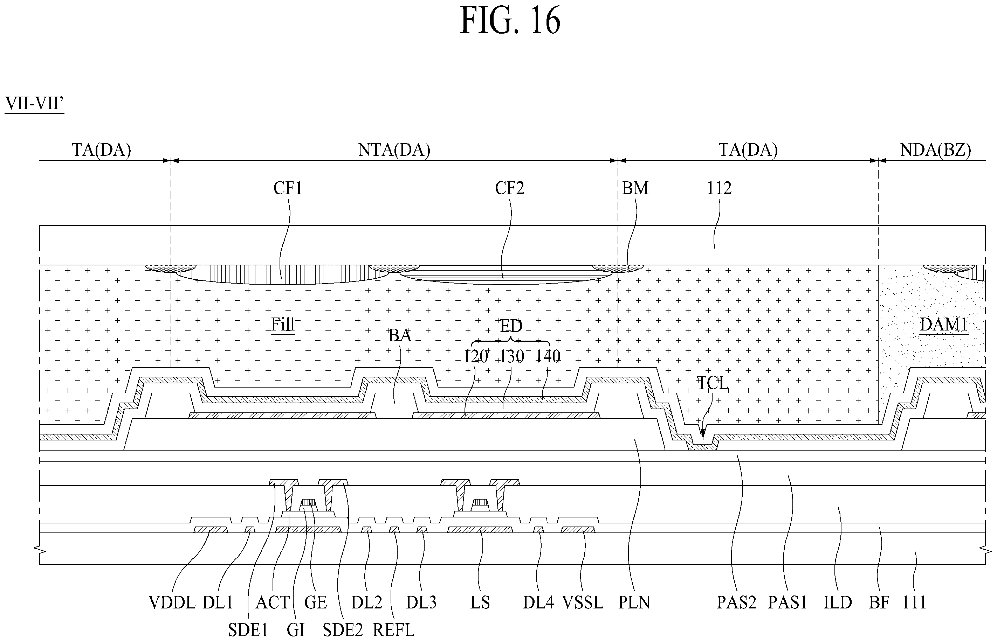

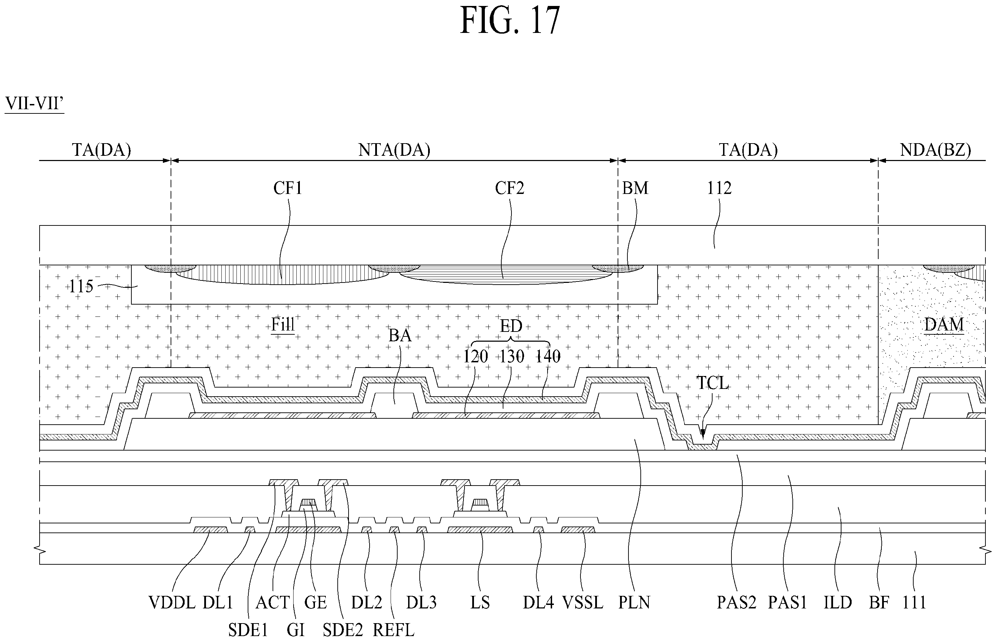

FIG. 15 illustrates the area D shown in FIG. 14, according to another embodiment of the present disclosure. FIG. 16 is a cross-sectional view of lines VII-VII' shown in FIG. 15, according to another embodiment of the present disclosure. FIG. 17 is another cross-sectional view of lines VII-VII' shown in FIG. 15, according to another embodiment of the present disclosure.

Referring to FIGS. 15 to 17 together with FIG. 14, the transparent display panel 110 may include a plurality of transmissive areas TA disposed parallel with each other in a first direction (or y-axis direction) and spaced apart from each other in a second direction (or x-axis direction) within the display area DA. Each of the plurality of transmissive areas TAs may have at least one trench line TCL extending in the first direction (or Y-axis direction).

A cuttable area CPA may be configured between the first dam pattern DAM1 and the second dam pattern DAM2. The cuttable area CPA may be an area having moisture permeability reliability by the first and second dam patterns DAM1, DAM2 and the at least one trench line (TCL), even if the transparent display panel 110 is cut.

The at least one trench line TCL may be disposed over the entire area of the transparent display panel 110. The at least one trench line TCL may be disposed overlapping the first and second dam patterns DAM1, DAM2.

Referring to FIG. 16, a transparent display panel 110 according to another embodiment of the present disclosure includes a light shielding layer LS disposed on a first substrate 111, a plurality of data lines DL1, DL2, DL3, DL4, a reference line REFL, a pixel power line VDDL, a common power line VSSL, a buffer layer BF, an active layer ACT of a thin film transistor, a gate insulator Gl, a gate electrode GE, a first source/drain electrode SDE1, and a second source/drain electrode SED2, an interlayer dielectric layer ILD, a first passivation layer PAS1, a second passivation layer PAS2, a planarization layer PLN, a light emitting element ED, a bank layer BA, and the like. It may also include a color filter CF1, CF2 disposed on a second substrate 112 facing the first substrate 111, a black matrix BM, and the like. The first substrate 111 and the second substrate 112 may be bonded together by a connecting member Fill.

The transparent display panel 110, according to other embodiments of the present disclosure, may include at least one trench line TCL formed by the removal of the organic light emitting layer 130 disposed on the second passivation layer PAS2 in the transmissive area TA.

The at least one trench line TCL may be disposed between the first dam pattern DAM1 and the light emitting element ED. The at least one trench line TCL may be disposed between the first dam pattern DAM1 and the light emitting element ED to prevent moisture from penetrating through the first dam pattern DAM1. Accordingly, the transparent display panel 110 according to other embodiments of the present disclosure can implement or realize a cuttable transparent display panel that can be divided into various sizes depending on the field and usage to which the transparent display panel 110 is applied, as moisture penetration can be prevented by the at least one trench line TCL even when the cuttable area CPA between the first dam pattern DAM1 and the second dam pattern DAM2 is cut by a cutting device such as a laser or a wheel.

Referring to FIG. 17, the transparent display panel 110 according to another embodiment of the present disclosure may further comprise a plurality of upper protective layers 115 covering the color filters CF1, CF2 of the second substrate 112.

The plurality of upper protective layers 115 may be spaced apart from each other with the transmissive area TA of the display area DA therebetween. The plurality of upper protective layers 115 may be configured to cover the color filter CF. For example, the plurality of upper protective layers 115 may be configured to cover the plurality of color filters CF1, CF2. Further, the plurality of upper protective layers 115 may be configured to cover the plurality of color filters CF1, CF2 and the black matrix BM. For example, the plurality of upper protective layers 115 may be composed of a glass material.

The transparent display panel 110 according to other embodiments of the present disclosure may include the upper protective layer 115 on the second substrate 112 spaced apart from each other together with the at least one trench line TCL cutting off or disconnecting the organic light emitting layer 130 on the first substrate 111, to block a moisture permeation path through the second substrate 112.

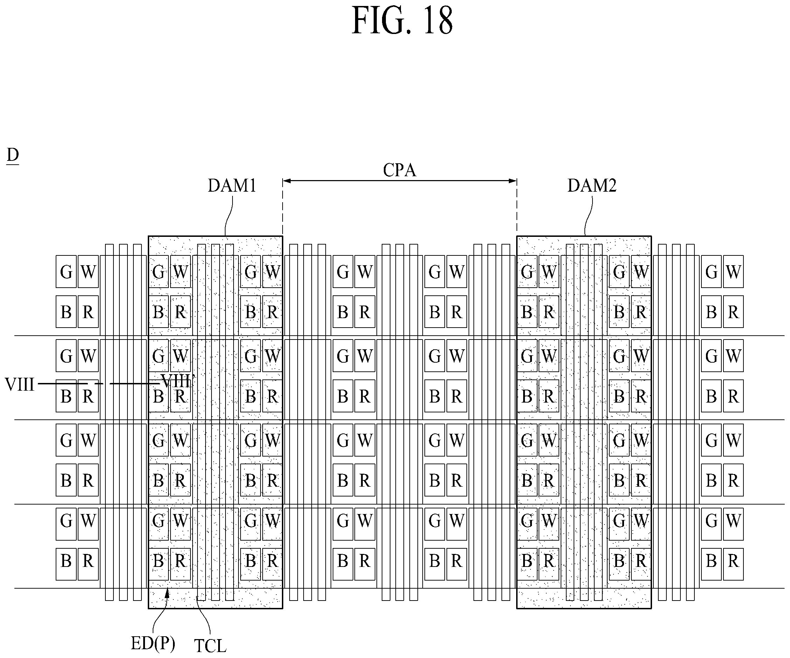

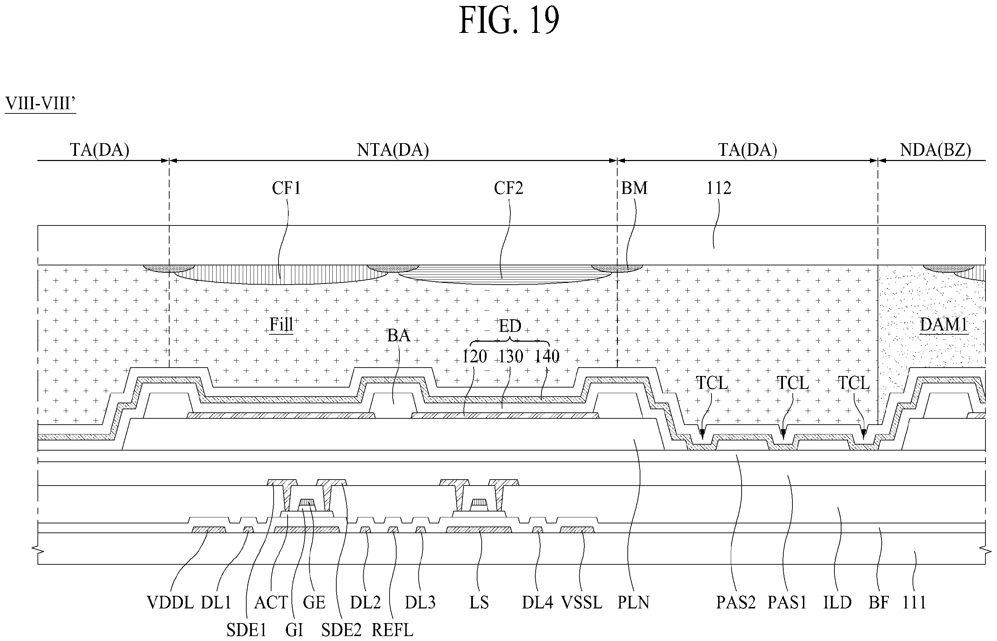

FIG. 18 illustrates the area D shown in FIG. 14, according to another embodiment of the present disclosure. FIG. 19 is another cross-sectional view of lines VIII-VIII' shown in FIG. 18, according to another embodiment of the present disclosure.

Referring to FIGS. 18 and 19, the transparent display panel 110 according to other embodiments of the present disclosure may include a plurality of transmissive areas TA disposed parallel with each other in a first direction (or y-axis direction) and spaced apart from each other in a second direction (or x-axis direction) within the display area DA. Each of the plurality of transmissive areas TAs may be disposed with at least one trench line TCL extending in the first direction (or Y-axis direction).

A cuttable area CPA may be configured between the first dam pattern DAM1 and the second dam pattern DAM2. The cuttable area CPA may be an area having moisture permeability reliability by the first and second dam patterns DAM1, DAM2 and the plurality of trench lines (TCLs), even if the transparent display panel 110 is cut.

The at least one trench line TCL may comprise a plurality of trench lines TCLs within a single transmissive area TA. For example, the at least one trench line TCL may include a plurality of trench lines TCLs spaced apart from each other in a second direction (or X-axis direction) within the transmissive area TA. For example, the plurality of trench lines TCLs may be disposed parallel with each other in a first direction (or Y-axis direction) and spaced apart from each other in a second direction (or X-axis direction). The plurality of trench lines TCLs may be disposed in multiples within the transmissive area TA to further prevent moisture permeation from the outside.

The plurality of trench lines TCLs may be disposed over the entire area of the transparent display panel 110. The plurality of trench lines TCLs may be arranged to overlap with the first and second dam patterns DAM1, DAM2. The plurality of trench lines TCLs may be disposed in parallel with the first and second dam patterns DAM1, DAM2. For example, the plurality of trench lines TCLs may be disposed parallel with each other and adjacent to the first and second dam patterns DAM1, DAM2.

Referring to FIG. 19, the transparent display panel 110 according to another embodiment of the present disclosure may include a plurality of trench lines TCLs formed by the removal of the organic light emitting layer 130 disposed on the second passivation layer PAS2 in the transmissive area TA. The plurality of trench lines TCLs may be disposed between the first dam pattern DAM1 and the light emitting element ED. The plurality of trench lines TCLs may be disposed in multiples between the first dam pattern DAM1 and the light emitting element ED to further prevent moisture from penetrating through the first dam pattern DAM1. Thereby, the transparent display panel 110 according to other embodiments of the present disclosure can implement or realize a cuttable transparent display panel that can be divided into various sizes depending on the field and usage to which the transparent display panel 110 is applied, as moisture penetration by the at least one trench line TCL can be prevented even when the cuttable area CPA between the first dam pattern DAM1 and the second dam pattern DAM2 is cut by a cutting device such as a laser or a wheel.

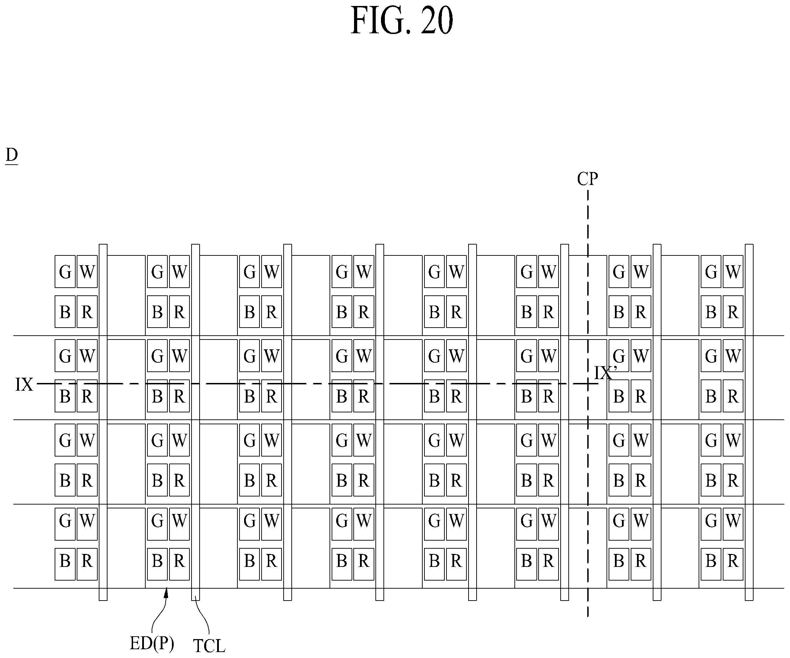

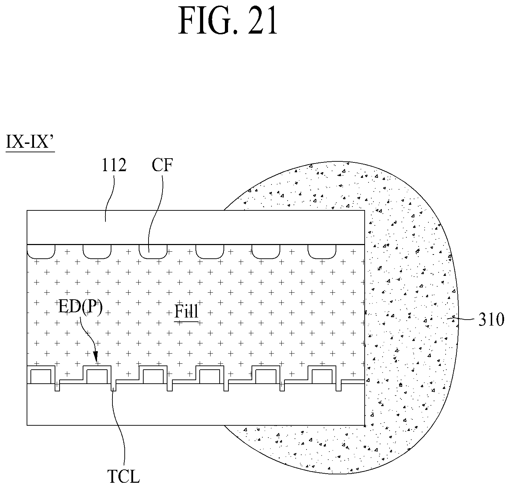

FIG. 20 illustrates the area D shown in FIG. 14, according to another embodiment of the present disclosure. FIG. 21 is a schematic cross-sectional view of lines IX-IX' shown in FIG. 20, according to another embodiment of the present disclosure.

Referring to FIGS. 20 and 21, the transparent display panel 110 according to other embodiments of the present disclosure may dispose a connecting member Fill between the first substrate 111 and the second substrate 112, and may omit the arrangement of the dam pattern.

The at least one trench line TCL may prevent moisture from permeating from the peripheral portion cut by the cutting part CP.

The transparent display panel 110, according to other embodiments of the present disclosure, may further include side sealing members 310 disposed on the peripheral edges of the first substrate 111 and the second substrate 112. The side sealing members 310 may serve to complement the moisture permeability reliability caused by the omission of the dam pattern. The transparent display panel 110 according to other embodiments of the present disclosure can prevent moisture permeation from the periphery by the at least one trench line TCL and the side sealing members 310 even though the dam pattern is omitted. Thereby, the transparent display panel 110 according to other embodiments of the present disclosure can be configured such that moisture permeation from the periphery can be prevented by the at least one trench line TCL and the side sealing member 310 even if any area is cut by a cutting device, such as a laser or a wheel, thereby enabling or realizing a cuttable transparent display panel that can be divided and fabricated into various sizes depending on the field and usage to which the transparent display panel 110 is applied.

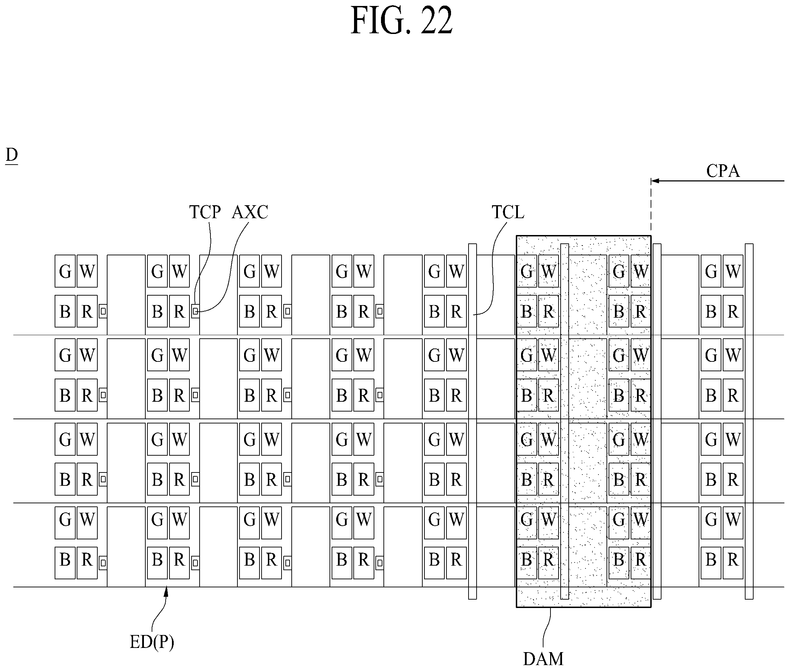

FIG. 22 illustrates the area D shown in FIG. 14, according to another embodiment of the present disclosure.

Referring to FIG. 22, the transparent display panel 110 according to another embodiment of the present disclosure may include at least one trench line TCL and at least one trench pattern TCP. The transparent display panel 110 may include a plurality of transmissive areas TA disposed parallel with each other in a first direction (or y-axis direction) and spaced apart from each other in a second direction (or x-axis direction) within the display area DA.

The at least one trench line TCL may be disposed in at least some of the plurality of transmissive areas TAs. For example, the at least one trench line TCL may be disposed in a transmissive area TA of the plurality of transmissive areas TAs that is overlapping or adjacent to the dam pattern DAM1. For example, the at least one trench line TCL may be formed by a laser drilling process, but embodiments herein are not limited thereto.

The at least one trench pattern TCP may be disposed in at least other portions of the plurality of transmissive areas TAs. The at least one trench pattern (TCP) may be disposed overlapping an auxiliary power contact part AXC within the transmissive area TA. For example, the at least one trench pattern TCP may be disposed in a transmissive area TA of the plurality of transmissive areas TAs that is not adjacent to the dam pattern DAM1. For example, the at least one trench pattern TCP may be formed by a laser spot patterning process, but embodiments of the present disclosure are not limited thereto.

The transparent display panel 110 according to other embodiments of the present disclosure may have at least one trench line TCL at locations that overlap or are adjacent to the dam pattern DAM1 and at least one trench pattern TCP at other locations. Thereby, the transparent display panel 110 according to other embodiments of the present disclosure may provide a secondary power contact structure by the at least one trench pattern TCP in areas that are not adjacent to the dam pattern DAM, and can implement or realize a cuttable transparent display panel that can be divided into various sizes depending on the field and usage to which the transparent display panel 110 is applied, as moisture penetration can be prevented by the at least one trench line TCL even when the cuttable area CPA adjacent to the dam pattern DAM is cut by a cutting device such as a laser or a wheel.

A transparent display apparatus according to various embodiments of the present disclosure will be described below.

A transparent display apparatus according to various embodiments of the present disclosure may include a substrate, a transmissive area, a non-transmissive having a light-emitting area where a light-emitting element is disposed, at least one power line disposed in the non-transmissive area on the substrate and extending in a first direction, at least one trench line disposed in the transmissive area on the substrate and extending in the first direction, and an auxiliary power contact part disposed in the transmissive area on the substrate, electrically connected to an auxiliary power line extending from the at least one power line in a second direction intersecting the first direction, and overlapping at least a portion of the at least one trench line.

According to various embodiments of the present disclosure, the at least one trench line may expose a portion of the auxiliary power contact part.

According to various embodiments of the present disclosure, the auxiliary power contact part may be formed of a same material as the auxiliary power line and may be in a same layer as the auxiliary power line.

According to various embodiments of the present disclosure, the auxiliary power contact part may be integrally formed with (or in) the auxiliary power line.

According to various embodiments of the present disclosure, the auxiliary power contact part may be formed of a different material than the auxiliary power line and may be in (or on) a different layer than the auxiliary power line.

According to various embodiments of the present disclosure, may further include at least one insulating layer between the auxiliary power contact part and the auxiliary power line, the auxiliary power contact part may be connected to the auxiliary power line via a contact hole penetrating the at least one insulating layer.

According to various embodiments of the present disclosure, the at least one trench line may be configured to cut off or disconnect an organic light emitting layer constituting the light-emitting element.

According to various embodiments of the present disclosure, the at least one power line may include a pixel power line and a common power line, and the at least one trench line may be disposed adjacent to the common power line.

According to various example embodiments of the present disclosure, a portion of the transmissive area located outside the at least one trench line opposite to the non-transmissive area may become a cuttable area.

According to various embodiments of the present disclosure, the light-emitting element may include a first electrode that includes a first split electrode and a second split electrode spaced apart from each other, a repair pattern may be further included to electrically connect to the first split electrode and the second split electrode, and the at least one trench line may not overlap the repair pattern.

According to various embodiments of the present disclosure, may further include a planarization layer on the substrate, and at least one insulating layer between the substrate and the planarization layer, the at least one trench line may be formed by removing at least a portion of the at least one insulating layer.

According to various embodiments of the present disclosure, the at least one trench line may include a plurality of trench lines spaced apart from one another.

According to various embodiments of the present disclosure, may further include an undercut line between the plurality of trench lines, the undercut line may be formed as a portion of the planarization layer and the at least one insulating layer.

According to various embodiments of the present disclosure, the undercut line may include a support line formed of at least a portion of the at least one insulating layer, and an eave line on the support line, projecting from the support line, and formed of the planarization layer, the undercut line may have an undercut area including a lower edge of the eave line and a side of the support line.

According to various embodiments of the present disclosure, the undercut line may be disposed over a portion of the auxiliary power contact part, and the undercut area of the undercut line may expose a portion of the auxiliary power contact part.

According to various embodiments of the present disclosure, the light-emitting element may include a first electrode, an organic light emitting layer, and a second electrode, and the organic light emitting layer may be cut off or disconnected by the undercut line.

According to various embodiments of the present disclosure, the second electrode may be in direct contact with the auxiliary power contact part by the undercut line.

According to various embodiments of the present disclosure, may further include a gate line extending in the second direction on the substrate, and a block pattern disposed at an intersection of the gate line and the undercut line.

According to various embodiments of the present disclosure, the block pattern may be between the undercut line and the gate line.

According to various example embodiments of the present disclosure, the block pattern may be formed of a same material in a same layer as at least one of the auxiliary power line and the auxiliary power contact part.

According to various embodiments of the present disclosure, the light-emitting element may include a first electrode, an organic light emitting layer, and a second electrode, the organic light emitting layer and the second electrode may extend to the transmissive area on the substrate, the organic light emitting layer may be cut off or disconnected by the at least one trench line on the transmissive area.

According to various embodiments of the present disclosure, the at least one trench line may be formed by removing at least a portion of the organic light emitting layer.

According to various embodiments of the present disclosure, the organic light emitting layer and the second electrode may be cut off or disconnected by the at least one trench line on the transmissive area.

According to various embodiments of the present disclosure, the at least one trench line may be formed by removing at least a portion of the organic light emitting layer and the second electrode.

According to various embodiments of the present disclosure, the at least one trench line may be formed by a laser drilling process.

According to various embodiments of the present disclosure, the second electrode may be in direct contact with the auxiliary power contact part by the at least one trench line.

According to various embodiments of the present disclosure, the at least one trench line may include at least two trench lines spaced apart from each other and in parallel with each other in the transmissive area on the substrate.

According to various embodiments of the present disclosure, the auxiliary power contact part may be formed of a same material as the first electrode and may be in a different layer than the first electrode.

According to various embodiments of the present disclosure, the transparent display apparatus may further include a display area and a non-display area outside the display area, at least one power shorting bar may be further included to extend in the second direction on the non-display area of the substrate, and the at least one trench line may intersect and overlap the at least one power shorting bar.

According to various embodiments of the present disclosure, the transparent display apparatus may further include an opposing substrate facing the substrate, a color filter disposed to correspond to the light-emitting area, and a connecting member connecting the substrate with the opposing substrate.

According to various embodiments of the present disclosure, the transparent display apparatus may further include a display area and a non-display area outside the display area, and a dam pattern may be disposed between the substrate and the opposing substrate, and disposed in (or on) the non-display area.

According to various embodiments of the present disclosure, the dam pattern may include a closed loop surrounding the non-display area of the substrate.

According to various embodiments of the present disclosure, the at least a portion of the dam pattern may be arranged in parallel with the at least one trench line.

According to various embodiments of the present disclosure, the at least one trench line may be arranged to overlap the dam pattern.

According to various embodiments of the present disclosure, the at least one trench line may be disposed adjacent to the dam pattern and arranged in parallel with the dam pattern.

According to various embodiments of the present disclosure, the at least one trench line may include at least two trench lines arranged in parallel to each other around the dam pattern.

According to various embodiments of the present disclosure, may further include a side sealing member configured to cover an edge of the opposing substrate.

According to various embodiments of the present disclosure, the opposing substrate may further include a plurality of upper protective layers covering the color filter, and the upper protective layers may be spaced apart from each other with the transmissive area between the upper protective layers.

It will be apparent to those skilled in the art that various modifications and variations may be made in the apparatus of the present disclosure without departing from the scope of the disclosure. Thus, it is intended that the present disclosure cover the modifications and variations of this disclosure provided that within the scope of the claims and their equivalents.

## Claims

1. A transparent display apparatus comprising:
a substrate;
a transmissive area;
a non-transmissive area including a light-emitting area where a light-emitting element is disposed;
at least one power line disposed in the non-transmissive area on the substrate and extending in a first direction;
at least one trench line disposed in the transmissive area on the substrate and extending in the first direction; and
an auxiliary power contact part disposed in the transmissive area on the substrate, the auxiliary power contact part being electrically connected to an auxiliary power line extending from the at least one power line in a second direction intersecting the first direction, and the auxiliary power contact part overlapping at least a portion of the at least one trench line.

2. The transparent display apparatus according to claim 1, wherein the at least one trench line exposes a portion of the auxiliary power contact part.

3. The transparent display apparatus according to claim 1 or claim 2, wherein the auxiliary power contact part is formed of a same material as the auxiliary power line and is in a same layer as the auxiliary power line, and optionally wherein the auxiliary power contact part is integrally formed with the auxiliary power line.

4. The transparent display apparatus according to claim 1 or claim 2, wherein the auxiliary power contact part is formed of a different material than the auxiliary power line and is in a different layer than the auxiliary power line, and optionally:
the transparent display apparatus further comprising at least one insulating layer between the auxiliary power contact part and the auxiliary power line,
wherein the auxiliary power contact part is connected to the auxiliary power line via a contact hole penetrating the at least one insulating layer.

5. The transparent display apparatus according to any preceding claim, further comprising:
a planarization layer on the substrate; and
at least one insulating layer between the substrate and the planarization layer, and optionally:
wherein the at least one trench line is formed by removing at least a portion of the at least one insulating layer.

6. The transparent display apparatus according to claim 5, wherein the at least one trench line comprises a plurality of trench lines spaced apart from one another.

7. The transparent display apparatus according to claim 6, further comprising an undercut line between the plurality of trench lines,
wherein the undercut line is formed as a portion of the planarization layer and the at least one insulating layer.

8. The transparent display apparatus according to any preceding claim, wherein the light-emitting element includes a first electrode, an organic light emitting layer, and a second electrode,
wherein the organic light emitting layer and the second electrode extend to the transmissive area on the substrate,
wherein the organic light emitting layer is cut off or disconnected by the at least one trench line on the transmissive area

9. The transparent display apparatus according to claim 8, wherein the second electrode is in direct contact with the auxiliary power contact part by the at least one trench line.

10. The transparent display apparatus according to claim 8 or claim 9, wherein the auxiliary power contact part is formed of a same material as the first electrode and is in a different layer than the first electrode.

11. The transparent display apparatus according to any of claims 8-10, further comprising a display area and a non-display area outside the display area,
wherein at least one power shorting bar is further included to extend in the second direction on the non-display area of the substrate, and
wherein the at least one trench line intersects and overlaps the at least one power shorting bar.

12. The transparent display apparatus according to any of claims 1-10, further comprising:
an opposing substrate facing the substrate;
a color filter disposed to correspond to the light-emitting area; and
a connecting member connecting the substrate with the opposing substrate.

13. The transparent display apparatus according to claim 12, further comprising a display area and a non-display area outside the display area,
wherein a dam pattern is disposed between the substrate and the opposing substrate, and disposed in the non-display area.

14. The transparent display apparatus according to claim 13, wherein the at least one trench line is arranged to overlap the dam pattern, or wherein the at least one trench line is disposed adjacent to the dam pattern and arranged in parallel with the dam pattern.

15. The transparent display apparatus according to claim 13 or claim 14, further comprising a side sealing member configured to cover an edge of the opposing substrate.
